# EUROPÄISCHE PATENTANMELDUNG

(11) **EP 4 306 683 A1**
(43) Veröffentlichungstag der Anmeldung: **17.01.2024**
(21) Anmeldenummer: 22184643.9
(22) Anmeldetag: 13.07.2022
(51) Int. Cl.: C30B 15/00, C30B 29/06, C30B 35/00, B01D 46/24

(54) **VORRICHTUNG ZUR REINIGUNG VON ABGASEN AUS EINER KRISTALLZIEHANLAGE**

(71) Anmelder: Siltronic AG, 81677 München (DE)
(72) Erfinder: Zeman, Otto, 84539 Ampfing (DE); Moos, Patrick, 84568 Pleiskirchen (DE); Bergmann, Helmut, 84524 Neuötting (DE)

(57) **Zusammenfassung**

Vorrichtung zur Abgasreinigung von Staub während der Kristallzüchtung, umfassend ein Gehäuse, in dem Filterkerzen in einem oberen Bereich des Gehäuses so verbaut sind, dass über eine erste Öffnung im Gehäuse eingeleitetes Rohgas von Partikel gereinigt werden kann und das entstehende Reingas über eine zweite Öffnung aus dem Gehäuse abgeleitet werden kann, ferner umfassend ein hohlkegelförmiges Bauteil mit einem Öffnungswinkel, das in einem unteren Teil des Gehäuses so verbaut ist, dass dessen Öffnung in Richtung der Filterkerzen im oberen Bereich zeigt, so dass Partikel, die sich von den Filterkerzen lösen im hohlkegelförmigen Bauteil gesammelt werden, ferner umfassend eine Absaugleitung mit einer Öffnung zum Absaugen der gesammelten Partikel, dadurch gekennzeichnet, dass die Öffnung nach unten zeigt.

## Beschreibung

Die Erfindung bezieht sich auf eine Vorrichtung zur Reinigung von Prozessabgasen enthaltend Stäube von Prozessanlagen zur Züchtung von Einkristallen.

Im Zuge der industriellen Herstellung von Kristallen entstehen regelmäßig Abgase, die brennbare Stäube enthalten. Dies gilt beispielsweise für das Ziehen von Einkristallen nach der Czochralski-Methode oder durch Zonenziehen, ebenso wie für die Herstellung von Kristallen mit polykristalliner Struktur. Zum Ziehen von Einkristallen aus Silizium nach der Czochralski-Methode wird Silizium, gegebenenfalls unter Zusatz von Dotierstoffen, wie beispielsweise Antimon, Arsen, Bor oder Phosphor, in einem heizbaren Quarztiegel vorgelegt und geschmolzen.

Durch Eintauchen eines Impfkristalls in die Schmelze wächst unter Drehung und vertikalem Ziehen des Impfkristalls an dessen Ende ein einkristalliner Kristallstab. Der Schmelze wird durch den Kontakt zur Oberfläche des Quarz-tiegels Sauerstoff zugeführt, der durch die Konvektion infolge der Wärmezuführung und der Rotation in der Schmelze verteilt wird.

Dadurch werden Oxide der Schmelzeninhaltsstoffe gebildet, die über die Schmelzoberfläche verdampfen. Diese Verbindungen bilden nach Resublimation den Anlagenstaub, welcher in der Anlage und in den Abgasleitungen anfällt. Neben unterschiedlicher Siliziumoxide SiOₓ (x = 0 bis 2) werden so insbesondere, aufgrund ihres hohen Dampfdruckes, die Sauerstoffverbindungen von Antimon und Arsen sowie Phosphor und bedingt auch Bor freigesetzt. Da die Kristallzüchtungsanlagen in der Regel unter leichtem Vakuum von Schutzgas, vorzugsweise Argon, durchströmt werden, gelangen die Oxide der Schmelzeninhaltsstoffe in unterschiedlichen Oxidationsstufen in den Abgasstrom der Anlage.

Sie bilden brennbare Industriestäube, die in nachgeschalteten Abgasfiltern Filterbrände oder Staubexplosionen verursachen können. Diese Stäube wirken neben ihrer teilweise erheblichen Giftigkeit für Menschen auch abrasiv, weshalb insbesondere auch die Abgase fördernden Pumpen durch eine Filterung vor ihnen geschützt werden müssen.

Im Stand der Technik finden sich einige Ansätze, wie mit diesen Stäuben umgegangen werden kann.

Das chinesische Gebrauchsmuster CN 20 469 0160 U zum Beispiel offenbart eine Reinigungsvorrichtung für Stäube, die eine Halterung und eine auf die Halterung aufgesetzte Filterkammer umfasst, wobei eine Seite der Filterkammer mit dem Lufteinlass und die gegenüberliegende Seite mit der Gasentlüftung ausgestattet ist. Am Boden der Filterkammer sammelt sich dabei der Staub der später manuell entfernt werden muss.

Das chinesische Paten CN 10 666 9301 A beschreibt ebenfalls eine Vorrichtung zur Entfernung von Staub. Die Entstaubungsanlage wird dabei zwischen einer Vakuumleitung und einer Vakuumpumpe der Kristallziehanlage montiert und kann dazu verwendet werden, flüchtige Stoffe aus einem Kristallziehprozess zu filtern. Auch hier werden die gesammelten Stäube in geeigneten Behältern oder Kompartments gesammelt. Es wird ferner vorgeschlagen, den inneren Raum der Vorrichtung mit mehreren elektromagnetischen Vibratoren auszustatten.
Zusätzlich zu CN 10 666 9301 A beschreibt das chinesische Patent
CN 10 505 6646 A eine Reinigung des Behälters mittels geeigneter Bürsten

Das deutsch Patent DE 10 2005 022 101 A1 beschreibt das Entfernen des Staubs während des Produktionsprozesses, wobei ein Filterwiderstand gemessen wird und bei Erreichen eines bestimmten Grenzwerts das Umleiten der Prozessabgase unter Umgehung des Filterbehälters eingeleitet wird.

Allen genannten Stellen im Stand der Technik gemein ist, dass der Staub zwar mehr oder minder gut gesammelt wird, aber im Anschluss der Staub manuell aus einem Behälter entweder in einem Sammelsack oder ohne entfernt werden muss. Dies stellt eine unzumutbare Gefährdung der Mitarbeiter dar, die dafür eingesetzt werden.

Aufgabe dieser Erfindung ist es daher eine Vorrichtung zur Verfügung zu stellen, die diesen Ansprüchen genügt.

Gelöst wird die Aufgabe durch die in den Ansprüchen beschriebenen Vorrichtungen.

### Kurzbeschreibung der Abbildungen

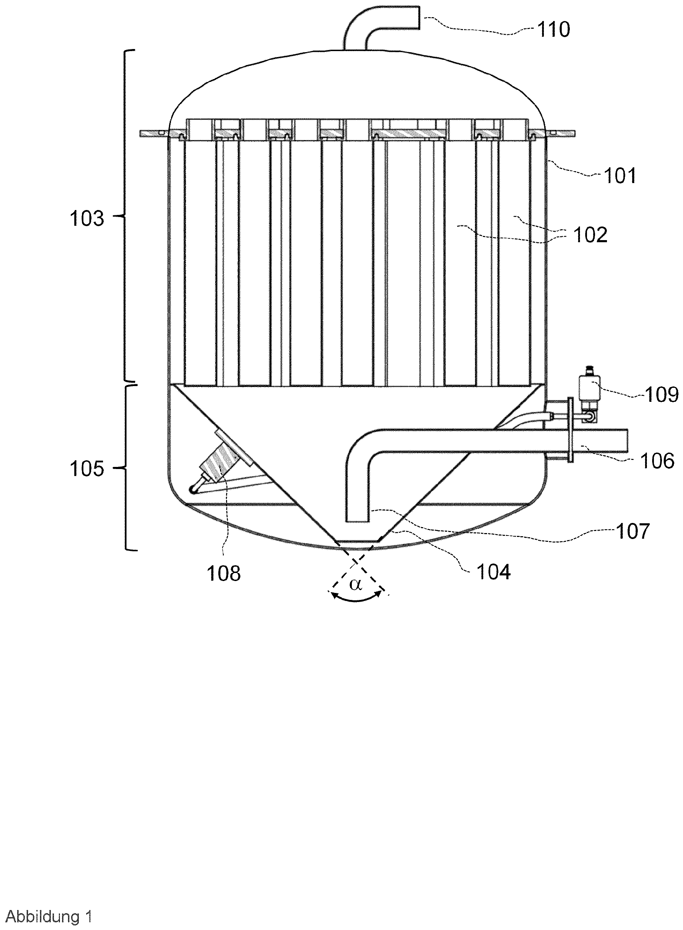

**Abbildung 1** zeigt eine Ausprägung der erfindungsgemäßen Vorrichtung. In einem Gehäuse **(101)** befinden sich Filterkerzen **(102),** die im oberen Teil **(103)** des Gehäuses **(101)** eingebaut sind. Über eine erste Leitung (nicht im Bild gezeigt) wird das von Partikel zu reinigende Rohgas in das Gehäuse eingebracht und das gereinigte Gas (Reingas) wird über eine zweite Leitung **(110)** wieder aus dem Gehäuse entfernt.

Ein hohlkegelförmiges Bauteil **(104)** mit einem Öffnungswinkel **α**, ist in einem unteren Bereich **(105)** so verbaut, dass Partikel, die sich von den Filterkerzen **(102)** lösen, im hohlkegel-förmigen Bauteil **(104)** gesammelt werden. Durch eine Absaugleitung **(106)** können die gesammelten Partikel/Staub abgesaugt werden, wobei eine Öffnung der Absaugleitung **(107)** in Richtung des Bodens des hohlkegelförmiges Bauteils **(104)** also nach unten gerichtet ist.

Eine bevorzugte Ausprägung der erfindungsgemäßen Vorrichtung enthält zusätzlich eine Vibrationseinheit **(108),** die an dem hohlkegelförmiges Bauteil **(104)** angebracht ist, so dass Partikel, die eventuell an der Innenseite des hohlkegelförmiges Bauteils **(104)** anhaften, nach unten gefördert werden. Besonders bevorzugt wird die Vibrationseinheit mit Druckluft betrieben, die durch eine Druckluftregelung **(109)** geregelt wird.

### Abkürzungen

- **101**: Gehäuse
- **102**: Filterkerzen
- **103**: oberer Bereich
- **104**: hohlkegelförmiges Bauteil
- **105**: unterer Bereich
- **106**: Absaugleitung
- **107**: nach unten Gerichtete Öffnung der Absaugleitung
- **108**: Vibrationseinheit
- **109**: Druckluftregelung für die Vibrationseinheit
- **110**: zweite Leitung zum Ableiten des gereinigten Gases (Reingasleitung)
- **α**: Öffnungswinkel des hohlkegelförmigen Bauteils

### Detaillierte Beschreibung der Erfindung

Wie beschrieben dampfen während des Kristallziehens zum Beispiel bei einem Ziehprozess nach Czochralski flüchtige Verbindungen (Dotierstoffe wie P, Sb, As; SiO etc.) kontinuierlich als Oxide aus der Si-Schmelze aus . Diese Verbindungen bilden nach Resublimation den Anlagenstaub, welcher in der Anlage und vor allem in den Abgasleitungen anfällt.

In der DE 10 2005 022 101 A1 wird beispielsweise beschrieben, wie dieser Stäube aus dem Abgas der Kristallziehanlage entfernt werden können. Die dort beschriebene Vorrichtung zur Filterung von Stäuben umfasst dabei einen Filterbehälter in dem mindestens ein Filter untergebracht ist und ein Vakuumsystem zum Einstellen eines Unterdrucks in der Prozessanlage und dem Filterbehälter.

Besonders bevorzugt sind ein oder mehrere Filterelemente, wie sie in der DE 10218491 B3 beschrieben sind, zu verwenden. Die verwendeten Filterelemente (Sinterfilter), sind bis mindestens 250°C temperaturbeständig und bestehen im Wesentlichen aus porösem und gesintertem Edelstahl oder entsprechender Keramik.

Des Weiteren haben sie eine Porengröße von 0,3 bis 12 µm, besonders bevorzugt von 3 bis 11 µm. Die Porengröße beträgt vorzugsweise 0,5 bis 5 µm, besonders bevorzugt 1 bis 3 µm.

Der Filterbehälter besteht vorzugsweise aus Edelstahl und ist bis mindestens 250°C temperaturbeständig. In Filtrierrichtung strömen die Prozessabgase von einem Eingang des Filterbehälters durch die verwendeten Filter zu einem Ausgang des Filterbehälters.

Ein Nachteil der im Stand der Technik beschriebenen Vorrichtungen besteht darin, dass der gefilterte, teils brennbare und giftige Staub sich am Boden des Filtergehäuses sammelt. Von dort muss er teils manuell entfernt werden, was dazu führen kann, dass das Personal in Kontakt mit der giftigen und gefährlichen Substanz kommen kann.

Die Erfinder haben erkannt, dass etwa eine einfache Rohrleitung, die den Staub nach unten hin absaugt und so das Problem lösen könnte, beim Betrieb verstopft und daher nicht geeignet ist.

Erfindungsgemäß umfasst die Vorrichtung zur Abgasreinigung von Staub während der Kristallzüchtung ein Gehäuse, in dem Filterkerzen in einem oberen Bereich des Gehäuses so verbaut sind, dass über eine erste Öffnung im Gehäuse eingeleitetes Rohgas von Partikel gereinigt werden kann und das entstehende Reingas über eine zweite Öffnung aus dem Gehäuse abgeleitet werden kann.

Ferner umfasst die Vorrichtung ein hohlkegelförmiges Bauteil mit einem Öffnungswinkel, das in einem unteren Teil des Gehäuses so verbaut ist, dass dessen Öffnung in Richtung der Filterkerzen im oberen Bereich zeigt, so dass Partikel, die sich von den Filterkerzen lösen im hohlkegelförmigen Bauteil gesammelt werden. Das hohlkegelförmiges Bauteil besteht dabei bevorzugt im Wesentlichen aus Edelstahl.

Ebenfalls umfasst die Vorrichtung eine Absaugleitung mit einer Öffnung zum Absaugen der gesammelten Partikel, wobei die Öffnung nach unten in Richtung der Partikel zeigt. Die Absaugleitung besteht dabei bevorzugt im Wesentlichen aus Edelstahl.

Die nach unten in Richtung der Partikel zeigende Öffnung der Rohrleitung umfasst bevorzugt ein Element, ganz besonders bevorzugt eine Muffe, das es ermöglicht, den Abstand zwischen dem Boden des Hohlkegelförmigen Bauteils und der Öffnung so einzustellen, dass die Gasströmung zum Abtransport des Staubes optimiert werden kann.

Bevorzugt ist, wenn an dem hohlkegelförmigen Bauteil eine Vibrationseinheit angebaut ist, so dass etwaig anhaftende Partikel nach unten gerüttelt werden. Besonders bevorzugt ist dabei, wenn die Vibrationseinheit mit Hilfe von einen Luftdruck betriebenen werden kann

Ebenfalls bevorzugt ist, wenn der Öffnungswinkel **α** des hohlkegelförmiges Bauteils mehr als 30° und weniger als 60°, bevorzugt 42° bis 47° beträgt.

Es ist auch bevorzugt, wenn zum Abreinigen des hohlkegelförmigen Bauteil eine Reinigungseinrichtung drehbar so montiert ist, dass sie das hohlkegelförmige Bauteil von Partikel von der Oberfläche des hohlkegelförmige Bauteil reinigen kann. Die Reinigungseinrichtung kann zum Beispiel als Bürste ausgeprägt sein, wobei die Borsten aus Graphit gefertigt wurden. Die Verwendung ist sowohl für sich als auch zusammen mit der Verwendung der Vibrationseinheit eine bevorzugte Ausprägung der Erfindung.

## Patentansprüche

1. Vorrichtung zur Abgasreinigung von Staub während der Kristallzüchtung, umfassend
ein Gehäuse **(101),** in dem Filterkerzen **(102)** in einem oberen Bereich **(103)** des Gehäuses **(101)** so verbaut sind, dass über eine erste Öffnung im Gehäuse eingeleitetes Rohgas von Partikel gereinigt werden kann und das entstehende Reingas über eine zweite Öffnung **(110)** aus dem Gehäuse abgeleitet werden kann, ferner umfassend ein hohlkegelförmiges Bauteil **(104)** mit einem Öffnungswinkel **α**, das in einem unteren Teil **(105)** des Gehäuses **(101)** so verbaut ist, dass dessen Öffnung in Richtung der Filterkerzen **(102)** im oberen Bereich **(103)** zeigt, so dass Partikel, die sich von den Filterkerzen **(102)** lösen im hohlkegelförmigen Bauteil **(104)** gesammelt werden,
ferner umfassend eine Absaugleitung **(106)** mit einer Öffnung **(107)** zum Absaugen der gesammelten Partikel,
**dadurch gekennzeichnet, dass**
die Öffnung nach unten zeigt.

2. Vorrichtung nach Anspruch 1, **dadurch gekennzeichnet, dass** an dem hohlkegelförmigen Bauteil **(104)** eine Vibrationseinheit **(108)** angebaut ist, so dass etwaig anhaftende Partikel nach unten gerüttelt werden.

3. Vorrichtung nach Anspruch 1 oder 2, **dadurch gekennzeichnet, dass** der Öffnungswinkel **α** mehr als 30° und weniger als 60°, bevorzugt 42° bis 47° beträgt.

4. Vorrichtung nach einem der vorigen Ansprüche, **dadurch gekennzeichnet, dass** eine Reinigungseinrichtung drehbar so montiert ist, dass sie das hohlkegelförmige Bauteil von Partikel reinigen kann.

5. Vorrichtung nach Anspruch 2, **dadurch gekennzeichnet, dass** die Vibrationseinheit **(108)** mit Hilfe von einen Luftdruck betriebenen werden kann.
